# EUROPÄISCHE PATENTANMELDUNG

(11) **EP 1 361 609 A2**
(43) Veröffentlichungstag der Anmeldung: **12.11.2003**
(21) Anmeldenummer: 03009951.9
(22) Anmeldetag: 30.04.2003
(51) Int. Cl.: H01L 23/04, H01L 23/24, H01L 21/54, H05K 5/00, H01F 27/02

(54) **Vergussgehäuse für elektrische und elektronische Bauelemente, Vorrichtung damit und Verfahren zu deren Herstellung**

(30) Priorität: 02.05.2002 DE 10219762
(71) Anmelder: Vacuumschmelze GmbH & Co. KG, 63450 Hanau (DE)
(72) Erfinder: Labatzke, Armin, 61476 Kronberg (DE)
(74) Vertreter: Patentanwälte Westphal, Mussgnug & Partner

(57) **Zusammenfassung**

Die Erfindung bezieht sich auf eine Vorrichtung mit einer seitlichen innenseitigen Gehäusewandung (1) und einem Innenraum eines Vergussgehäuses, zumindest einem elektrisch und/oder elektronisch wirkenden Bauelement (2) und einer Vergussmasse (3), welche in den Innenraum eingegossen ist.

Zur Verbesserung des Zusammenhaltes zwischen der Gehäusewandung (1) und der Vergussmasse (3) bei späteren Temperaturwechseln wird vorgeschlagen, die Gehäusewandung (1) im Kontaktbereich mit der Oberfläche der Vergussmasse (3) in Vergussstellung unter einem nicht senkrechten Winkel (α) zur Waagerechten verlaufen zu lassen (4, 5).

## Beschreibung

Die Erfindung bezieht sich auf ein Vergussgehäuse für elektrische oder elektronische Bauelemente, eine daraus gebildete Vorrichtung mit den oberbegrifflichen Merkmalen des Patentanspruchs 1 bzw. ein Verfahren zum Herstellen einer solchen.

Allgemein bekannt ist es, elektrische und elektronische Bauelemente, beispielsweise induktive Bauelemente und integrierte Schaltungen in Gehäusen unterzubringen. Gründe dafür können eine ausreichende Spannungsfestigkeit und ein Schutz vor Umwelteinflüssen wie Schmutz, Staub, Spritzwasser und ähnlichem sein. Die Bauelemente werden dazu aus Kostengründen zumeist in sogenannten verlorenen Formen, den Gehäusen eingesetzt, woraufhin der restliche Innenraum der Gehäuse vergossen wird. Für die Gehäuse werden dabei temperaturbeständige Thermoplaste bevorzugt. Als Vergussmassen werden zumeist temperaturbeständige Epoxidharze verwendet, wobei häufig sehr flexible Vergussmassen gewählt werden, um eine zu starke Verspannung der eingegossenen Bauelemente zu verhindern.

Problematisch ist bei derartigen Vorrichtungen, dass die Gehäuse und Vergussmassen sehr unterschiedliche Ausdehnungskoeffizienten haben. Insbesondere bei oberflächenmontierten Einrichtungen (SMD - surface mounted devices) treten bei der Weiterverarbeitung in z.B. den sogenannten Reflow-Lötprozessen sehr große Temperaturdifferenzen auf. Diese führen dazu, dass sich der kompakte Vergussblock von einer oder mehreren Gehäuseseiten ablöst. Ist diese Seite konstruktionsbedingt auch die Seite mit den Anschlussstiften, so können bei Temperaturwechseln in diesem Bereich angelötete Kupferlackdrähte über die Länge des sich ausbildenden Spaltes gedehnt werden, da sie einerseits in der Vergussmasse fest eingebettet sind und andererseits an den Kontaktstiften angelötet sind. Nach häufigeren Temperaturwechseln kann eine solche Dehnung bis zum Drahtbruch führen, was dann den Totalausfall des Bauelementes zu Folge hat.

In der Praxis hat sich gezeigt, dass sowohl der einmalige Reflow-Prozess als auch wenige Temperaturwechsel bei Drahtstärken von 100µm zumeist nicht zum unmittelbaren Ausfall solcher Bauelemente führen. Weitergehende Untersuchungen unter Temperaturwechselbedingungen, wie sie nach den derzeitigen Datenblättern in der Anwendung zulässig sind, dass heißt über Temperaturbereiche von -25°C bis +85°C, führten jedoch nach ca. 100 Wechseln zu Drahtbrüchen von einigen Prozent der Bauelemente. Bei 500 Wechseln waren in verschiedenen Versuchen zwischen 10% und 40% der Bauelemente ausgefallen. Auch unterschiedliche Kombinationen von Vergussharzen und Gehäusematerialien sowie Varianten bei der Aushärtung führten nicht zur prinzipiellen Lösung des Problems, da immer mit unterschiedlichen Ausdehnungskoeffizienten zu rechnen ist.

Die Aufgabe der Erfindung besteht darin, eine Vorrichtung mit einer Gehäusewand, einem darin eingesetzten elektrisch und/oder elektronisch wirkenden Bauelement und einer den Gehäuseinnenraum ausfüllenden Vergussmasse dahingehend zu verbessern, dass das Auftreten von Spalten zwischen Vergussmasse und Gehäusewand reduziert oder vermieden wird. Ferner sollen ein Verfahren zum Herstellen einer solchen Vorrichtung und ein Gehäuse für eine solche vorgeschlagen werden.

Diese Aufgabe wird durch eine Vorrichtung mit einer Gehäusewandung, zumindest einem darin eingesetzten elektronischen und/oder elektronisch wirkenden Bauelement und einer Vergussmasse mit den Merkmalen des Patentanspruchs 1 gelöst. Verfahren zum Herstellen einer solchen Vorrichtung sind Gegenstand der Patentansprüche 5 und 7. Ein Vergussgehäuse zum Herstellen einer solchen Vorrichtung bzw. zum Einsetzen bei einem solchem Verfahren ist Gegenstand des Patentanspruchs 8.

Vorteilhafte Ausgestaltungen sind Gegenstand abhängiger Ansprüche.

Darunter, dass die Gehäusewandung in Vergussstellung im Bereich der Oberkante der Vergussmasse unter einem nicht senkrechten Winkel zur Waagerechten verläuft, ist insbesondere zu verstehen, dass die Vorrichtung in einer Lage betrachtet wird, in der die Vergussmasse in den Innenraum eingegossen wird und verfestigt. Unter der Oberkante der Vergussmasse wird dabei die große zentrale Fläche der Vergussmasse verstanden. Alternativ kann für die Ausrichtung eine Stellung der Vorrichtung betrachtet werden, bei der die Lagedefinition von der waagerechten Oberfläche der später verfestigten Vergussmasse ausgeht.

Unter elektrischen und elektronisch wirkenden Bauelementen werden verschiedenartigste Bauelemente verstanden, welche nicht nur rein elektrisch bzw. elektronisch wirksam sind, sondern welche auch elektromagnetisch, optoelektronisch, piezoelektrisch usw. wirksam sind. Darunter sind auch magnetische Bauelemente in Wechselwirkung mit elektrischen Leitern oder umgekehrt zu verstehen. Insbesondere kann auch die Vergussmasse selber Bestandteil der elektrischen oder elektronischen Einrichtung sein, z.B. wenn sie bestimmte elektrische oder magnetische Eigenschaften aufweist.

Baulich gesehen wird eine Gehäusewandung bereitgestellt welche im Kontaktbereich der Oberfläche der Vergussmasse unter einem nicht senkrechten Winkel zur Waagerechten verläuft. Vorzugsweise wird somit eine im Kontaktbereich mit der Oberfläche der Vergussmasse abgeschrägte Gehäusewandung in diesem Bereich verwendet.

Der ideale Winkel oder geeignete Winkel wird dabei vorteilhafterweise abhängig von den Materialeigenschaften der Gehäusewandung und der Vergussmasse gewählt. Dabei soll die Kohäsionskraft zwischen den verschiedenen Materialien und die Adhäsionskraft zwischen den Materialen vorteilhafterweise nicht in gleicher Richtung wirken. Dies wird dadurch erreicht, dass der Übergangswinkel nicht 90° bzw. 270°beträgt.

Neben einer abgeschrägten Gehäusewandung, insbesondere abgeschrägten Oberkante der Gehäusewandung ist auch eine abgerundet verlaufene Gehäusewandung verwendbar. Eine gleichmäßig abgeschrägte Wandung ist für die Befüllung mit einer üblichen Vergussmasse besonders gut geeignet, da die Füllhöhe nicht berücksichtigt werden muss. bzw. Im Fall einer speziellen Vergussmasse, die eine bestimmte Sondereigenschaft aufweist, ist eine abgerundete Gehäusewandung vorteilhaft, da durch die Füllhöhe der Vergussmasse der Übergangswinkel zwischen Oberfläche der Vergussmasse und Gehäusewandung variabel festgelegt wird. Ein Gehäuse mit einer abgerundeten Oberfläche ist somit für den Einsatz wechselnder Vergussmassen bei zudem nur geringer Stückzahl der zu fertigenden Vorrichtungen besonders vorteilhaft verwendbar.

Physikalisch gesehen wird somit der ideale Benetzungswinkel zwischen Gehäusewandung und Vergussmasse angestrebt, wobei idealerweise der Winkel zwischen der Oberfläche der Vergussmasse und der seitlichen Gehäusewandung dem Benetzungswinkel zwischen diesen beiden entsprechen würde. Jedoch sind auch davon noch abweichende Winkel zweckmäßig, insbesondere wenn die Kohäsionskraft der aneinander angrenzenden Materialien nicht mehr die Richtung der Adhäsionskraft hat.

Bei einem Verfahren zum Herstellen einer solchen Vorrichtung wird entsprechend vorteilhafterweise ein Vergussgehäuse verwendet, welches eine entsprechend abgeschrägte bzw. abgerundete Seitenwandung aufweist. Sofern keine solchen speziellen Vergussgehäuse bereitstehen, kann vor dem Verfüllen mit der Vergussmasse auch eine entsprechende Abschrägung in der Seitenwandung ausgebildet werden, z.B. eingefräst werden.

Gemäß einem anderen Verfahren zum Herstellen von derartigen Vorrichtungen mit jedoch senkrecht zur Haupt-Oberfläche der ausgehärteten Gussmasse angeordneten Gehäusewandungen wird das Vergussgehäuse vor dem Befüllen mit der Vergussmasse um eine zur Senkrechten um einen gewünschten Winkel verkippten Achse drehbar gelagert, wobei das Gehäuse beim Befüllen mit der Vergussmasse um die Achse derart gedreht wird, dass der Rand der Oberfläche der Vergussmasse, welcher mit der Gehäusewandung in Kontakt ist, sich um einen nicht senkrechten Winkel zur Gehäusewandung verfestigt. Um den Hauptbereich der Vergussmasse waagerecht auszubilden, kann das Verkippen auch erst durchgeführt werden, nachdem die eigentliche Haupt-Vergussmasse eingefüllt und verfestigt wurde, wobei in einem nachfolgenden Schritt zusätzliche Vergussmasse nach dem Verkippen und während des Drehens eingebracht wird. Diese nachträglich eingebrachte Vergussmasse soll dabei eine dem Material eigene Verbindung mit der bereits voll oder zumindest großteils verfestigten Vergussmasse des ersten Füllschrittes eingehen.

Ein für solche Vorrichtungen bzw. Verfahren vorteilhaftes Vergussgehäuse weist eine seitliche Gehäusewandung auf, welche entsprechend dem Wandungsmaterial und dem einzufüllenden Material der Vergussmasse abgeschrägte Bereiche in der Seitenwandung, insbesondere eine abgeschrägte Oberkante aufweist.

Da der Abschrägungswinkel jeweils punktuell für den Kontaktbereich der Oberfläche der Vergussmasse an der Seitenwandung zu betrachten ist, kann ein solches Vergussgehäuse vorteilhafterweise auch eine abgerundet verlaufende Wandung aufweisen, so dass der Füllwinkel abhängig von der Füllhöhe der Vergussmasse variabel wählbar ist, so dass nicht für jedes verschiedene Materialverhältnis zwischen Gehäusewandung und Vergussmasse ein eigenes Vergussgehäuse mit einer eigenen Abschrägung bereitzustellen ist.

Die Abschrägung kann sich dabei im Extremfall auch über die gesamte Gehäusewandung erstrecken, wobei dann eine zick-zackoder sägezahnförmige Wandung besonders zweckmäßig ist. Ebenso kann sich der Rundungsbereich bei Bedarf bis zum inneren Boden der Gehäusewandung erstrecken, z.B. in Form einer Schlangenlinie.

In besonders geringer Dimensionierung sind auch Aufrauhungen der inneren Gehäusewandung als Abschrägungen und Abrundungen in Miniaturform einsetzbar. Diese ermöglichen bei unregelmäßiger Verteilung eine zumindest jeweils punktuell gute Fixierung über eine Vielzahl von Punkten auf der Oberfläche.

Ein Ausführungsbeispiel wird nachfolgend anhand der Zeichnung näher erläutert. Es zeigen:
- Fig. 1.: einen Schnitt durch einen Teil einer Anordnung aus einem Vergussgehäuse mit einem elektronischen Bauelement, welches im Innenraum des Vergussgehäuses eingegossen ist;
- Fig. 2A, 2B: Prinzipskizzen zur Verdeutlichung des physikalischen Prinzips, welches vorliegend ausgenutzt wird;
- Fig.3.: eine zweite Ausführungsform mit einer im Vergleich zur Fig.1 abgerundeten Gehäusewandung.
- Fig. 4A/4B: Ausführungsformen mit nach innen gerichtet ausgebildeten Abschrägungen bzw. Abrundungen der seitlichen Gehäusewandungen und
- Fig. 5.: eine Prinzipskizze für ein alternatives Verfahren zum Herstellen einer elektrischen bzw. einer elektronischen Vorrichtung mit einem herkömmlichen Vergussgehäuse jedoch einer an dessen Innenwandung schräg angrenzenden Oberfläche der eingefüllten Vergussmasse.

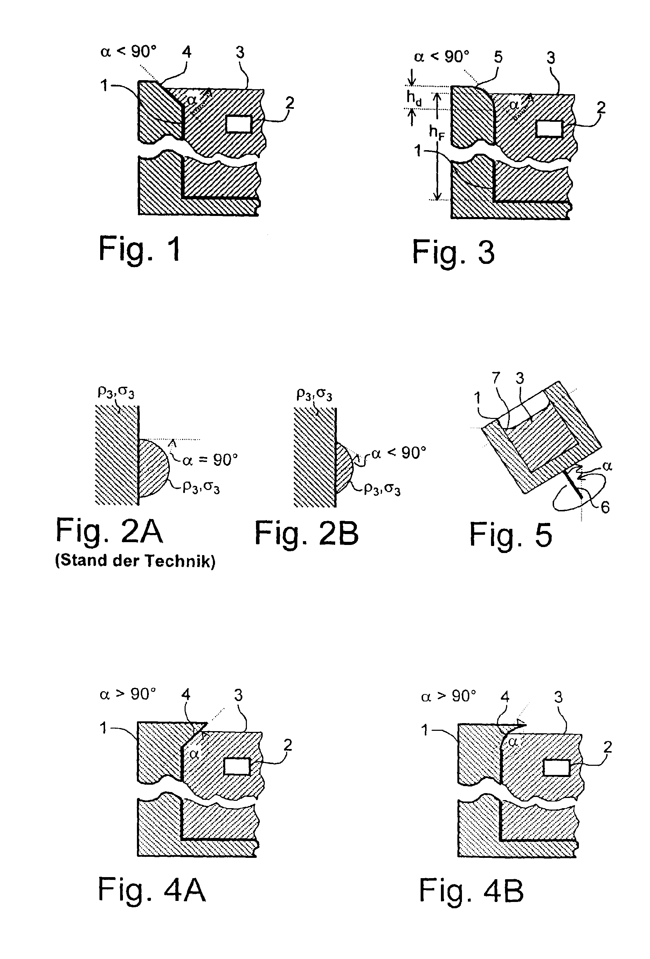

Wie aus Fig. 1 ersichtlich, besteht eine solche Vorrichtung aus einer Gehäusewandung 1 eines Vergussgehäuses, einem oder mehreren elektrischen und/oder elektronischen Bauelementen 2, die sich im Innenraum des Vergussgehäuses befinden, und einer in den Innenraum eingefüllten Vergussmasse 3. Dargestellt ist die gesamte Anordnung in einer Vergussstellung, dass heißt mit einem nach oben hin offenen Vergussgehäuse. Üblicherweise wird die Vergussmasse 3 in dieser Stellung in den Innenraum des Vergussgehäuses eingefüllt und verfestigt daraufhin. Im Fall einer rein senkrecht verlaufenden seitlichen Gehäusewandung 1 würde somit die Oberkante bzw. Oberfläche der Vergussmasse 3 senkrecht zur Gehäusewandung 1 verlaufen. Alternativ ist dieses Winkelverhältnis auch anhand der waagerechten Oberfläche der Vergussmasse 3 des flächenmäßigen Hauptanteils dieser Vergussmasse 3 bestimmbar.

Bei der dargestellten Ausführungsform ist die seitliche Gehäusewandung 1 in dem Kontaktbereich mit der Oberfläche bzw. Oberkante der Vergussmasse 3 abgeschrägt. Die entsprechende Abschrägung 4 führt dabei von der Innenseite der Gehäusewandung 1 aus nach schräg oben in Richtung der oberen Außenkante der Gehäusewandung 1 hin. Dadurch verläuft die Oberfläche der ausgehärteten Vergussmasse 3 nicht mehr unter einem senkrechten Winkel sondern unter einem Winkel α. Nachfolgend soll der Winkel α dabei von einer Ebene der Seitenwandung 1 von unten her durch die Vergussmasse 3 hindurch zu deren Oberfläche definiert sein. Bei der in Fig. 1 dargestellten Ausführungsform beträgt der Winkel α somit weniger als 90°. Bei ersten Versuchen hat sich ein besonders geeigneter Winkel α im Bereich von 45° ergeben. Idealerweise würde jedoch für jedes Materialverhältnis zwischen Gehäusewandung 1 und Vergussmasse 3 ein besonders geeigneter Winkel α individuell bestimmt werden.

Das physikalische Grundprinzip, welches hier ausgenützt wird, wird dabei anhand Fig. 2A und 2B veranschaulicht. Fig. 2A zeigt eine seitliche Gehäusewandung und einen halbkugelförmigen Tropfen einer Vergussmasse 3. Der Winkel α beträgt in diesem Fall 90°. Das Material der Gehäusewandung 1 wird insbesondere durch die Oberflächenspannung σ₁ und die Materialdichte ρ₁ bestimmt. Entsprechend wird das Material der Vergussmasse 3 durch dessen Oberflächenspannung σ₃ und Dichte ρ₃ bestimmt. Fig. 2B zeigt eine Situation mit einem bevorzugteren Übergangswinkel α zwischen der Gehäusewandung 1 und der Oberfläche der Vergussmasse 3 im Kontaktbereich. Der dargestellte Winkel α beträgt weniger als 90°.

Als Material für die Gehäusewandung 1 werden bevorzugt Kunststoffe, insbesondere Thermoplaste oder Duroplaste ausgewählt, wobei die Auswahl sich unter anderem nach der zu erwartenden Temperaturbeanspruchung bei der Weiterverarbeitung und im späteren Einsatz richtet. Insbesondere bei Ausführungsformen als oberflächenmontierbare Bauelemente (SMD) werden üblicherweise temperaturbeständige Thermoplaste wie PA (Polyamid), PPS (Polyphenylensulfid) oder LCP (Liquid Crystal Polymer) verwendet.

Als Vergussmassen 3 werden recht temperaturbeständige Epoxidharze bevorzugt. Natürlich können auch andere geeignete Materialien für die Gehäusewandungen 1 und Vergussmassen 3 verwendet werden.

Der konstruktiven Ausgestaltung der Gehäusewandung 1 aus Fig. 1 liegt somit das physikalische Grundprinzip zugrunde, dass bei vergossenen Gehäusen keine oder weniger Ablösungen vorkommen, wenn sich der Vergussmeniskus bzw. Winkel α bei üblichen Materialkombinationen nicht an der senkrechten Gehäusewandung 1 ausbildet. Abgesehen von der Möglichkeit, dass die Vergussmasse die Hülle der Gehäusewandung 1 leicht übersteigt, so dass sich der Vergussmeniskus nicht an der senkrechten inneren Gehäusewandung sondern auf den oberen, waagerechten Teil der Gehäusewandung 1 ausbildet, wird bevorzugt ein Vergussgehäuse mit einer innenseitig entsprechend abgeschrägten Gehäusewandung 1 verwendet.

Neben der Verwendung eines Vergussgehäuses mit einer innenseitig im oberen Bereich der Gehäusewandung 1 ausgebildeten Abschrägung 4 können derartige Abschrägungen auch im inneren Bereich der Innenwandung 1 ausgebildet werden, so dass die Innenwandung beispielsweise eine in Schnittdarstellung zickzack-förmige oder sägezahnförmige Kontur annehmen würde. Dabei können die Winkel α der einzelnen Stufen unterschiedlich zur Senkrechten geneigt sein, so dass je nach Vergussmaterial durch die Wahl einer verschiedenen Vergusshöhe das Winkelverhältnis zwischen Vergussmaterial 3 und Gehäusewandung 1 gewählt werden kann.

Wie aus Fig. 3 ersichtlich, weist ein besonders bevorzugtes Vergussgehäuse eine seitliche Gehäusewandung 1 auf, die anstelle einer größer flächigen Abschrägung 4 eine Rundung 5 aufweist. Der Winkel α zwischen der Gehäusewandung 1 und der Oberfläche der Vergussmasse 3 bestimmt sich gehäuseseitig aus der jeweiligen Tangente längst der innenseitigen Gehäusewandung 1 in dem Kontaktbereich mit der Oberfläche der Vergussmasse 3. Je nach Füllhöhe h_{F} der Vergussmasse 3 ergibt sich somit ein unterschiedlicher Winkel α. Dabei kann die Rundung 5 von der Oberkante der Gehäusewandung 1 aus nach unten hin über eine Übergangshöhe h_{d} einem gleichmäßigen Radiusverlauf unterliegen, kann aber auch elliptisch oder anders gerundet verlaufen.

Während die Abschrägung 4 bzw. Rundung 5 der Vergussgehäuse aus den Fig. 1 bzw. Fig. 3 von der Innenseite zur Außenseite hin verlaufen, so dass sich Winkel α kleiner 90°ergeben, stellen die Fig.4A und 4B entsprechende Gehäusewandungen 1 dar, bei denen die Winkel größer 90° sind. In diesen Fällen bildet die innenseitige Gehäusewandung 1 somit einen dachartigen Vorsprung, welcher den Innenraum des Vergussgehäuses teilweise überragt.

Derartige Vergussgehäuse können vorteilhafterweise in Spritzgusstechnik gefertigt werden, wie dies für sich bekannt ist. Durch die konstruktive Gestaltung der hier beschriebenen innenseitigen Gehäusewandungen 1 mit den Abschrägungen 4 bzw. Rundungen 5 entstehen bei der Fertigung von Spritzgusswerkzeugen keine besonderen Aufwände, so dass die Herstellung der Spritzgusswerkzeuge und letztendlich die Herstellung der Vergussgehäuse nicht zu einer Verteuerung führt. Dadurch, dass die Haftung zwischen Gehäusewandung 1 und Vergussmasse 3 erhöht wird und somit Ablösungen zwischen den beiden verschiedenartigen Materialien verhindert oder zumindest verringert werden, kann jedoch die Anzahl der bereits nach der Herstellung oder nach deren Einbau bzw. in deren Betrieb defekt werdenden Vorrichtungen verringert werden, so dass Fertigung und späterer Einsatz dieser Vorrichtungen kostengünstig gestaltbar sind. Neben dem Kostenaspekt erhöht sich auch die Betriebssicherheit bereits eingebauter elektronischer Vorrichtungen, die Temperaturschwankungen unterliegen.

Erste Versuche mit jeweils gleichem Gehäusematerial und Gießharz als Vergussmasse 3 zeigten nach 500 Temperaturschocks zwischen -40°C und +125°C an fünf abgeschrägten Wandungen 1 keine Ablösungen. An fünf Vorrichtungen mit senkrecht verlaufenden Gehäusewandungen 1 waren drei von diesen nach ca. 100 Temperaturschocks ausgefallen und bei den restlichen beiden zeigte sich bereits eine Erweiterung von Anfangsrissen von den Seitenrändern her, wobei die Erweiterung noch im Gang war.

Fig. 5 zeigt den Prinzipaufbau einer Anordnung zum Verfüllen eines Vergussgehäuses mit einer herkömmlichen innenseitigen Gehäusewandung 1 ohne eine Abschrägung bzw. Abrundung. Um den Übergangsbereich zwischen der Oberfläche des Vergussmaterials 3 und der seitlichen Gehäusewandung 1 unter einem Winkel α zu erzielen, wird das Vergussgehäuse verkippt und um die Achse 6, um die es verkippt wurde, gedreht. Vorteilhafterweise wird in einem ersten Vergussschritt die Vergussmasse 3 in herkömmlicher Art und Weise bis zu einem Abstand unter der innenseitigen oberen Kante der Gehäusewandung 1 eingefüllt und zumindest teilweise verfestigt. In einem zweiten Verfüllungsschritt erfolgt dann das Verkippen und das Drehen des Vergussgehäuses um die Achse 6, während eine weitere Menge 7 der Vergussmasse eingefüllt wird. Durch die rotierende Bewegung und den Verkippungswinkel α, der bei der dargestellten Ausführungsform ±90° zur senkrechten verläuft, bildet sich ein Übergangsbereich, in dem die Oberfläche des Vergussmaterials 3 in herkömmlicher Vergussstellung von der waagerechten aus ansteigend verläuft und unter einem nicht senkrechten Winkel an der Gehäusewandung 1 anliegt.

Vorteilhaft sind solche Verfahren und Vorrichtungen besonders auch bei dem Einsatz einer magnetischen Vergussmasse 3, die zumindest nach dem Verfestigen magnetisch ausgerichtete Bestandteile aufweist. Eine solche magnetische Vergussmasse 3 kann nach dem Verfestigen einen Magneten ausbilden und mit entsprechenden eingegossenen elektrischen Bauelementen zusammen z.B. einen Transformator ausbilden. Ein derart ausgebildeter Transformator erzeugt im Betrieb nicht nur Wärme sondern auch Schwingungen, was zu einer besonders kritischen Beanspruchung des gesamten Bauelements führen kann, so dass eine besonders sichere Befestigung gemäß der vorstehenden Beschreibung zwischen Vergussmasse 3 und der Gehäusewandung 1 besonders wichtig ist.

## Patentansprüche

1. Vorrichtung mit
- einer seitlichen innenseitigen Gehäusewandung (1) und einem davon umgebenen Innenraum eines Vergussgehäuses,
- zumindest einem elektrisch und/oder elektronisch wirkenden Bauelement (2) im Innenraum und
- einer Vergussmasse (3), welche in den Innenraum eingegossen ist,
**dadurch gekennzeichnet, dass**
- die Gehäusewandung (1) zumindest im Kontaktbereich mit der Oberfläche der Vergussmasse (3) in Vergussstellung bzw. in Stellung mit waagerechter Oberfläche der Vergussmasse (3) unter einem nicht senkrechten Winkel (*α*) zur Waagerechten verläuft (4, 5).

2. Vorrichtung nach Anspruch 1, bei der die Kohäsionskraft zwischen den Materialen der Gehäusewandung (1) und der Vergussmasse (3) und die Adhäsionskraft zwischen den Materialien der Gehäusewandung (1) und der Vergussmasse (3) nicht in gleicher Richtung wirken, dass heißt insbesondere nicht um 90° bzw. 270° zum Winkel (α) zwischen Gehäusewandung (1) und Oberfläche der Vergussmasse (3) wirken.

3. Vorrichtung nach Anspruch 1 oder 2, bei der der Benetzungswinkel (α ± 90°) zwischen der Gehäusewandung (1) und der Oberfläche der Vergussmasse (3) ungleich 90° ist.

4. Vorrichtung nach einem vorstehenden Anspruch, bei der die Gehäusewandung (1) im Kontaktbereich um die Oberfläche der Vergussmasse (3) eine Abrundung (5) aufweist.

5. Verfahren zum Herstellen einer Vorrichtung, insbesondere einer Vorrichtung nach einem vorstehenden Anspruch, mit einer innenseitigen seitlichen Gehäusewandung (1) und einem Innenraum eines Vergussgehäuses, mit zumindest einem elektrisch und/oder elektronisch wirkenden Bauelement (2) und mit einer Vergussmasse (3) im Innenraum, bei dem
- als das Vergussgehäuse ein Vergussgehäuse mit einer zumindest im Kontaktbereich der Oberfläche der Vergussmasse (3) unter einem Winkel (α) relativ zur endgültigen Oberfläche der Vergussmasse (3) schräg, nicht senkrecht verlaufenden inneren Gehäusewandung (1) bereitgestellt wird und
- das Vergussgehäuse abschließend mit der Vergussmasse (3) vergossen wird.

6. Verfahren nach Anspruch 5, bei dem
die seitliche Gehäusewandung (1) innenseitig vor dem Vergießen zumindest im vorgesehenen späteren Kontaktbereich (h_{F}) mit der Oberfläche der Vergussmasse (3) abgeschrägt oder abgerundet wird.

7. Verfahren zum Herstellen einer Vorrichtung, insbesondere einer Vorrichtung nach einem vorstehenden Anspruch, mit einer innenseitigen seitlichen Gehäusewandung (1) und einem Innenraum eines Vergussgehäuses, mit zumindest einem elektrisch und/oder elektronisch wirkenden Bauelement (2) und mit einer Vergussmasse (3) im Innenraum, bei dem
- das Vergussgehäuse vor dem endgültigen Verfüllen mit der Vergussmasse (3) um eine in Vergussstellung zur senkrechten um einen Winkel (α ± 90°) verkippten Achse (6) drehbar gelagert wird und
- das Vergussgehäuse beim Befüllen mit zumindest einem letzten Anteil der Vergussmasse (3) und/oder bei deren Verfestigen derart um die Achse (6) gedreht wird, dass der Rand der Oberfläche der Vergussmasse (3) sich unter einem nicht senkrechten Winkel (α) zur Gehäusewandung (1) verfestigt.

8. Vergussgehäuse für eine Vorrichtung nach einem der Ansprüche 1 bis 4 bzw. für ein Verfahren nach einem der Ansprüche 5 bis 7 mit einer seitlicher Gehäusewandung (1), welche eine Abschrägung (4) und/oder Abrundung (5) aufweist, welche zumindest über einen Teil der Gehäusewandung (1) schräg zur einer geplanten Oberfläche einer eingefüllten Vergussmasse (3) verläuft.

9. Vergussmasse für eine Vorrichtung nach einem der Ansprüche 1 bis 4 bzw. für ein Verfahren nach einem der Ansprüche 5 bis 7, wobei die Vergussmasse (3) nach dem Verfestigen magnetisch ausgerichtete Bestandteile aufweist.

10. Vorrichtung, Verfahren bzw. Vergussgehäuse nach einem der vorstehenden Ansprüche, wobei der Winkel (α) kleiner 80° bzw. größer 100° ist.

11. Vorrichtung, Verfahren bzw. Vergussgehäuse nach einem der vorstehenden Ansprüche, wobei der Winkel (α) kleiner 70° bzw. größer 110° ist.

12. Vorrichtung, Verfahren bzw. Vergussgehäuse nach einem der vorstehenden Ansprüche, wobei der Winkel (α) kleiner 50° bzw. größer 140° ist.
